Europäisches Patentamt

European Patent Office

Office européen des brevets

(19)

(11) Veröffentlichungsnummer: **0 036 061**
**B1**

(12) **EUROPÄISCHE PATENTSCHRIFT**

(45) Veröffentlichungstag der Patentschrift:
18.07.84

(51) Int. Cl.³: **C 23 C 11/00**, C 23 F 1/00,
C 23 C 15/00

(21) Anmeldenummer: 81100007.4

(22) Anmeldetag: 02.01.81

(54) **Verfahren und Rohrreaktor zur Dampfphasenabscheidung und zum Plasmaätzen.**

(30) Priorität: 08.02.80 DD 218955

(43) Veröffentlichungstag der Anmeldung:
23.09.81 Patentblatt 81/38

(45) Bekanntmachung des Hinweises auf die Patenterteilung:
18.07.84 Patentblatt 84/29

(84) Benannte Vertragsstaaten:
AT DE GB NL

(56) Entgegenhaltungen:
WO - A - 79/00776
WO - A - 81/00420
DE - A - 2 536 871
DE - A - 2 738 891
DE - A - 2 951 453
DE - B - 2 810 554
FR - A - 2 408 913

(73) Patentinhaber: VEB Zentrum für Forschung und Technologie Mikroelektronik, Karl-Marx-Strasse, DDR-8080 Dresden (DD)

(72) Erfinder: Möller, Rainer, Dr.-Ing., Stephanstrasse 55, DDR-8023 Dresden (DD)
Erfinder: Voigt, Reinhard, Dipl.-Phys., Gerh.-Hauptmann-Strasse 18, DDR-8102 Langebrück (DD)
Erfinder: Kleinert, Michael, Dipl.-Chem., Dörnichtweg 37, DDR-8080 Dresden (DD)

(74) Vertreter: de Bruijn, Leendert C. Nederlandsch Octrooibureau et al, Johann de Wittlaan 15, NL-2502 LS 's-Gravenhage (NL)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

## Beschreibung

### Anwendungsgebiet der Erfindung

Die erfindungsgemäße Lösung kann für plasmachemische Dampfphasenabscheidungen sowie zum Plasmaätzen von unterschiedlichsten Materialien, insbesondere zur Bearbeitung von Halbleitersubstraten eingesetzt werden.

### Charakteristik der bekannten technischen Lösungen

Bekannte Lösungen zum plasmachemischen Ätzen benutzen als Reaktor ein dielektrisches Rohr, in dem die Scheiben axial oder radial angeordnet sind und das auf seinem Mantel Elektroden zur induktiven (Spule) oder kapazitiven (Platten) Ankopplung der HF-Energie besitzt. (z. B. US-P 4 141 811) Die Scheiben sind nach dem Zünden des Plasmas, diesem völlig ausgesetzt. Bei Verwendung dieser Vorrichtung wird die Energie der einzelnen Plasmabestandteile vor allem auf die Peripherie der zu bearbeitenden scheibenförmigen Substrate konzentriert. (IPC Product Bulletin 7101).

Es ist auch bekannt, daß die Substrate außerhalb des aktiven Plasmas angeordnet sind, um die oben genannten Nachteile zu vermeiden.

Ein entsprechender Rohrreaktor ist in der DE-OS 2 536 871 beschrieben und besteht aus einem Reaktionsrohr mit außen aufgebrachten Elektroden und einem eingebrachten perforierten Metallzylinder, in dem sich die zu ätzenden Substrate in einer isolierenden Halterung befinden. Der perforierte Zylinder begrenzt das Plasma, das nur im Raum zwischen Reaktorinnenwand und dem perforierten Metallzylinder brennt. So werden Ionen, Elektronen und Strahlung von den Substraten ferngehalten, während die freien Radikale mit ihrer relativ großen Lebensdauer infolge einer geeigneten Gasführung durch die Löcher des Metallzylinders die Plasmaregion verlassen und auf die Oberfläche der im Ätztunnel angeordneten Substrate gelangen können.

Ein wesentlicher Nachteil eines solchen Rohrreaktors ist sein isotropes Ätzverhalten, das besonders beim Strukturierungsätzen kleinster Strukturen stört. Die Gleichheit der Ätzrate in vertikaler und horizontaler Richtung bewirkt ein Unterätzen der Ätzmasken und somit ein Verbreitern der Ätzstrukturen.

Neue experimentelle Untersuchungen zeigen, daß einige für den Ätzprozeß im Plasma wichtige freie Radikale eine extrem kurze Lebensdauer besitzen und deshalb in einem Reaktor, mit von den Substraten räumlich getrennter Plasmaerzeugung, für den Ätzprozeß ausfallen. Diese Radikale sind zum Ätzen bestimmter Stoffe — z. B. Aluminiumschichten — jedoch unbedingt erforderlich.

Es sind auch Planarreaktoren bekannt (z. B. DE-OS 2 708 720), die ein anisotropes Ätzverhalten mit starker Unterdrückung des lateralen Ätzens besitzen und bei denen sich die Substrate unmittelbar in der Plasmazone befinden. Ein solcher Reaktor ist jedoch wesentlich aufwendiger als ein einfacher Rohrreaktor und weist ferner eine wesentlich geringere Aufnahmekapazität an Substraten auf.

Für die plasmachemische Schichtabscheidung werden die beschriebenen Rohrreaktoren nicht eingesetzt, da die in einfachen Reaktoren erfolgende starke Aktivierung der peripheren Bereiche eine starke Schichtabscheidung am Rande der Scheiben bewirkt, während die Abscheiderate zum Zentrum derselben stark abfällt. Derartig ungleichmäßig beschichtete Substrate sind nicht weiterverwendbar. Reaktoren mit von der Plasmaregion räumlich getrennter Substratanordnung sind für die Schichtabscheidungen nicht verwendbar, weil auf dem Weg von der Anregung der Reaktionsgase im Plasmabereich bis zu den Substraten eine vorzeitige homogene Reaktion in der Gasphase stattfindet, die zur unerwünschten Partikelbildung und somit zur Qualitätsminderung der Schichten führt.

Daher werden für die plasmachemische Schichtabscheidung aufwendige Plasmareaktoren eingesetzt (DE 2 251 571), in denen Plasma- und Substratzone nicht voneinander getrennt sind. Diese haben den großen Nachteil, daß nur eine geringe Stückzahl von Substratscheiben auf der Planarelektrode Platz finden.

### Ziel der Erfindung

Ziel der Erfindung ist es, eine große Stückzahl Substrate auf ökonomische Weise plasmachemisch zu beschichten oder plasmachemisch zu ätzen.

### Darlegung des Wesens der Erfindung

Der Erfindung liegt die Aufgabe zugrunde, einen Rohrreaktor so zu gestalten, daß scheibenförmige Substrate gleichmäßig mit dem Plasma eines Reaktionsgases beaufschlagt werden und eine plasmachemische Schichtabscheidung oder plasmachemische Ätzung über die gesamte Substratfläche gleichmäßig erfolgt.

Die Aufgabe schließt ein vorteilhaftes Arbeitsverfahren zur Betreibung des Rohrreaktors ein.

Erfindungsgemäß wird ein Rohrreaktor zur plasmachemischen Dampfphasenabscheidung und zum Plasmaätzen, der im wesentlichen aus einem wahlweise beheizbaren mit einer Gaszu- und Gasableitung sowie mit Anschlüssen für die zur Plasmaerzeugung notwendigen Hochfrequenzenergie versehenen Rohr besteht, in dem eine ein- und ausfahrbare Substrathalterung, auf der die Substrate in stapelförmiger Zuordnung parallel und im gleichen Abstand zueinander vorgesehen sind, angeordnet ist, dadurch gekennzeichnet, daß die Substrathalterung aus einem elektrisch leitenden Material besteht und mit einem Ausgang eines HF-Generators verbunden ist, so daß sich im Betrieb zwischen den einzelnen Substraten des gesamten auf gleichem HF-Potential liegendem Substratstapels ein intensives und gleichmäßiges Plasma bilden kann und daß der Substratstapel in seiner gesamten Länge von einer gegenüber der Substrathalterung isolierten und mit dem anderen Ausgang des HF-Generators verbundenen zylinderförmigen Elektrode umgeben ist.

Erfindungsgemäß ist zwischen dem aus einem Isoliermaterial bestehenden Außenrohr des Rohrreaktors und der Substrataufnahme ein perforierter Metallzylinder als zylinderförmige Elektrode angeordnet, wobei zwischen Außenrohr und zylinderförmige Elektrode die Gaszu- und Gasabführung angeordnet sind.

Eine weitere Ausführungsform besteht darin, daß die Gaszu- und Gasabführung innerhalb der zylinderförmigen Metallelektrode angeordnet sind. Dabei befinden sich vorzugsweise das Gaszu- und Gasabführungsrohr auf dem gleichen Potential wie die zylinderförmige Elektrode, die den Substratstapel umgibt.

Vorteilhafterweise ist die Gaszu- und Gasabführung in die zylinderförmige Elektrode integriert. Vorzugsweise besteht diese aus einem doppelwandigen topfförmigen Zylinder, dessen Innenwand mit Gasein- und Gasaustrittsöffnungen versehen ist.

Ferner sieht die Erfindung vor, daß das Außenrohr des Rohrreaktors aus Metall oder aus einem anderen leitfähigen Material besteht und durch Anschluß an einem Ausgang des HF-Generators als zylinderförmige Elektrode ausgebildet ist, in der die mit dem anderen Ausgang des HF-Generators in Wirkungsverbindung stehende Substrathalterung angeordnet ist. Zur Sicherheit des Bedienungspersonals ist dabei die zylinderförmige Elektrode mit dem Massepotential des HF-Generators verbunden.

Zur Verbesserung der Gleichmäßigkeit der Substratbearbeitung ist die Substrathalterung drehbar im Rohrreaktor angeordnet.

Zur Erhöhung der Produktivität des Rohrreaktors sind die Substrate erfindungsgemäß paarweise mit den nicht zu bearbeitenden Flächen direkt aneinander liegend parallel und im gleichen Abstand zueinander in der Substrathalterung angeordnet. Eine erhebliche Vereinfachung der Gaszu- und Gasabführung ergibt sich, wenn die Substrate mit ihrer Flächennormalen senkrecht zur Rohrlängsachse im Rohrreaktor angeordnet sind.

Das erfindungsgemäße Verfahren zum Betreiben des Rohrreaktors zeichnet sich dadurch aus, daß ein Gasstrom in die von 4,5 – 20 mm gewählten Zwischenräume der Substrate so gerichtet wird, daß er den Substratstapel quer durchströmt und sich im Reaktionsrohr ein Druck im Bereich von 0,01 – 1 kPa aufbaut. Der Abstand der zylinderförmigen Elektrode zur peripheren Begrenzung der Substrate bzw. Substrathalterung wird größer als der Abstand der Substrate zueinander gehalten. Zur Erzeugung eines intensiven und gleichmäßigen Plasmas zwischen den Substraten, werden diese mit einer HF-Energiedichte im Bereich von 0,1 – 0,5 W/cm² Scheibenoberfläche beaufschlagt.

Die Vorteile der erfindungsgemäßen Lösung bestehen darin, daß eine hochqualitative Schichtabscheidung oder Schichtätzung im einfachen, von außen in üblicher Weise wahlweise beheizbaren Rohrreaktoren durchgeführt werden kann, was vorher nur in aufwendigen Planarreaktoren möglich war. Ferner übertrifft die Produktivität der erfindungsgemäß ausgestalteten Rohrreaktoren die von Planarreaktoren auf Grund der stapelförmigen Anordnung der Substrate und der damit verbundenen maximalen Nutzung des Reaktionsraumes, wesentlich.

Bei der Schichtabscheidung ist es weiter von großem Vorteil, daß die Substratheizung außerhalb des Reaktionsrohres untergebracht werden kann. Dieses Prinzip ist in den weit verbreiteten Niederdruck-CVD-Anlagen (LPCVD-Anlagen) verwirklicht. Diese Anlagen können auf einfache Weise durch Nachrüstung mit den erfindungsgemäßen Merkmalen zu leistungsfähigen Rohrreaktoren zur plasmachemischen Schichtabscheidung bzw. Schichtätzung umgerüstet werden.

Ausführungsbeispiele

Die Erfindung soll an Hand von vier Vorrichtungsbeispielen und einem Verfahrensbeispiel zum Betreiben des Rohrreaktors näher erläutert werden. In der Zeichnung zeigt

Fig. 1 einen Rohrreaktor mit perforierter zylinderförmiger Elektrode,

Fig. 2 einen Rohrreaktor mit Zylinderelektrode,

Fig. 3 einen Rohrreaktor mit doppelwandiger Zylinderelektrode,

Fig. 4 eine vertikal aufgebaute Ätzvorrichtung mit Metallaußenrohr als Rohrreaktor.

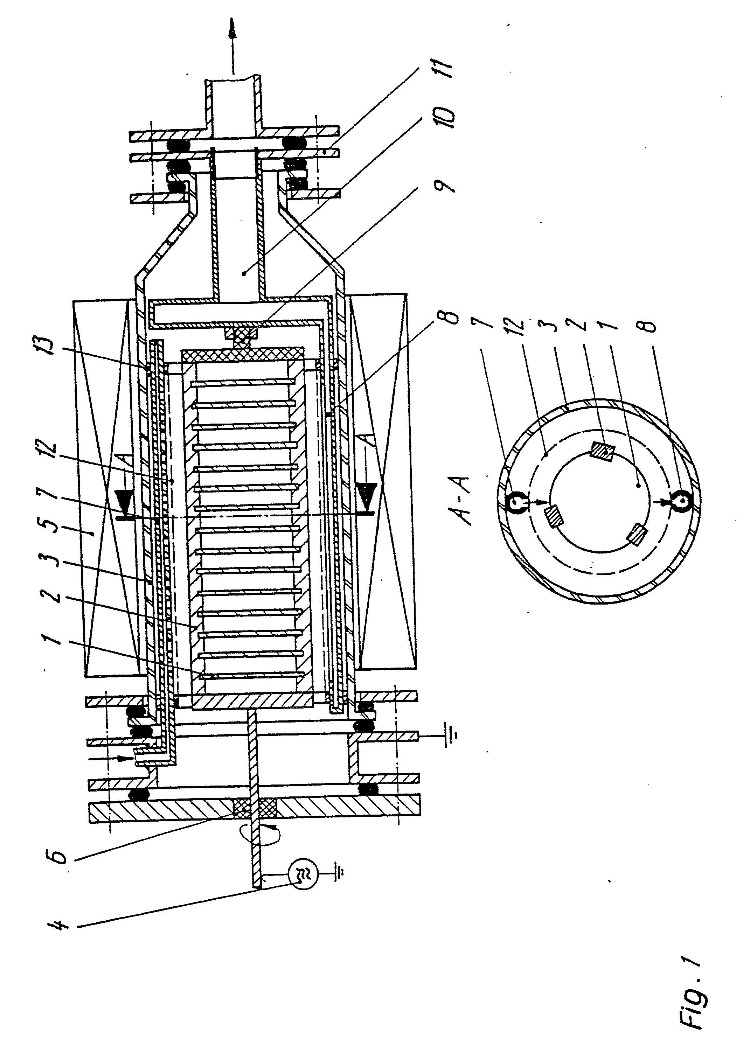

In Fig. 1 ist ein Rohrreaktor zur Abscheidung von Schichten dargestellt. Die in den Rohrreaktor ein- und ausfahrbare Substrathalterung 2 besteht aus einem elektrisch leitenden Material und ist mit einem Ausgang des HF-Generators 4 verbunden. Die mit Substraten 1 bestückte Substrathalterung 2 ist in dem aus Isoliermaterial bestehenden Außenrohr 3 des Rohrreaktors mittels Gegenlager 9 drehbar gelagert. Eine gegenüber der Substrathalterung 2 isoliert angeordnete perforierte zylinderförmige Elektrode 12 ist mittels Abstandsringen 13 im Außenrohr 3 befestigt und umgibt die Substrathalterung 2 auf der gesamten mit Substraten bestückten Länge. Die Elektrode 12 ist mit dem anderen Ausgang des HF-Generators 4 verbunden. Der Anschluß des HF-Generators 4 an die Substrathalterung 2 erfolgt über die HF-Drehdurchführung 6. Die Zylinderelektrode 12 befindet sich auf Massepotential. Das Gaszuführungsrohr 7 und das Gasabführungsrohr 8 sind zwischen perforierter Elektrode 12 und dem Außenrohr 3 angeordnet.

Das Außenrohr 3 ist von einer Heizung 5 umgeben. Am Rohrreaktor ist eine Absaugleitung 10 durch ein Gewindeflansch 11 angeschlossen.

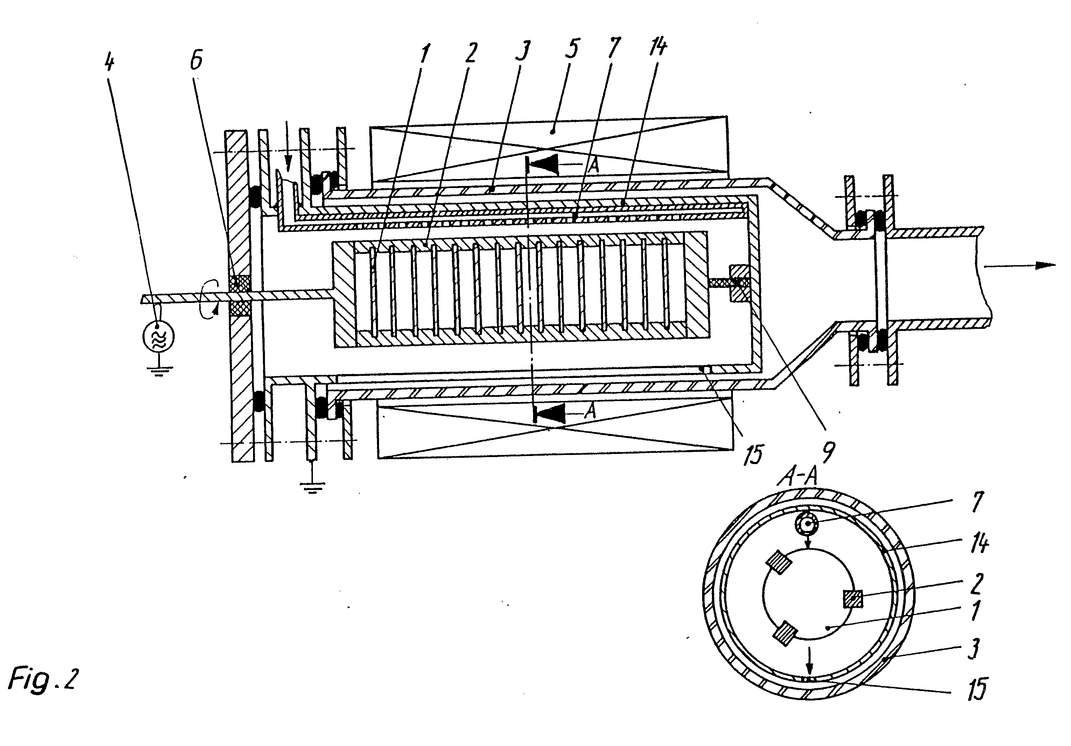

Im Ausführungsbeispiel gemäß Fig. 2 ist bei sonst gleicher Anordnung die perforierte Elektrode 12 durch eine Zylinderelektrode 14 ersetzt und die Gasführung verändert. Das Gaszuführungsrohr 7 liegt innerhalb der Zylinderelektrode 14, die auf der gegenüberliegenden Seite einen Gasauslaßschlitz 15 besitzt. Die hintere Stirnseite der Zylinderelektrode 14 ist verschlossen, damit sich die gewünschte Strömungsrichtung quer durch den Substratstapel einstellt.

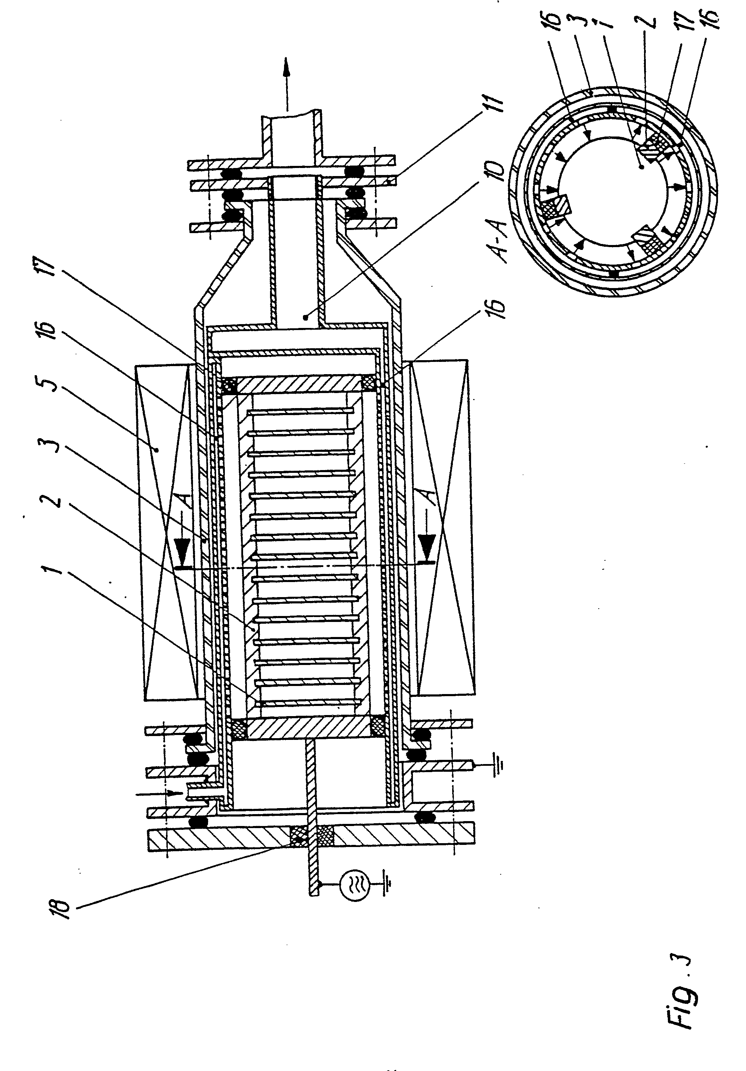

Im Ausführungsbeispiel gemäß Fig. 3 ist eine doppelwandige topfförmige Zylinderelektrode 16 mittels isolierenden Abstandsringen 17 im Außenrohr 3 angeordnet. Die Gaszu- und Gasabführung ist in die Zylinderelektrode 16 integriert. Die eine Hälfte des Raumes zwischen den Wänden der doppelwandigen Zylinderelektrode 16 dient der Gaszuführung, während durch die andere das Gas abgeführt wird. Die Gaseintritts- und Gasaustrittsöffnungen sind flächenförmig über jeweils einen Halbzylinder der Zylinderelektrode 16 verteilt, dadurch erfolgt eine gleichmäßige Beschichtung der Substrate, so daß auf eine Substratbewegung verzichtet werden kann. Hierbei ergibt sich eine einfache HF-Durchführung 18 für diesen Rohrreaktor.

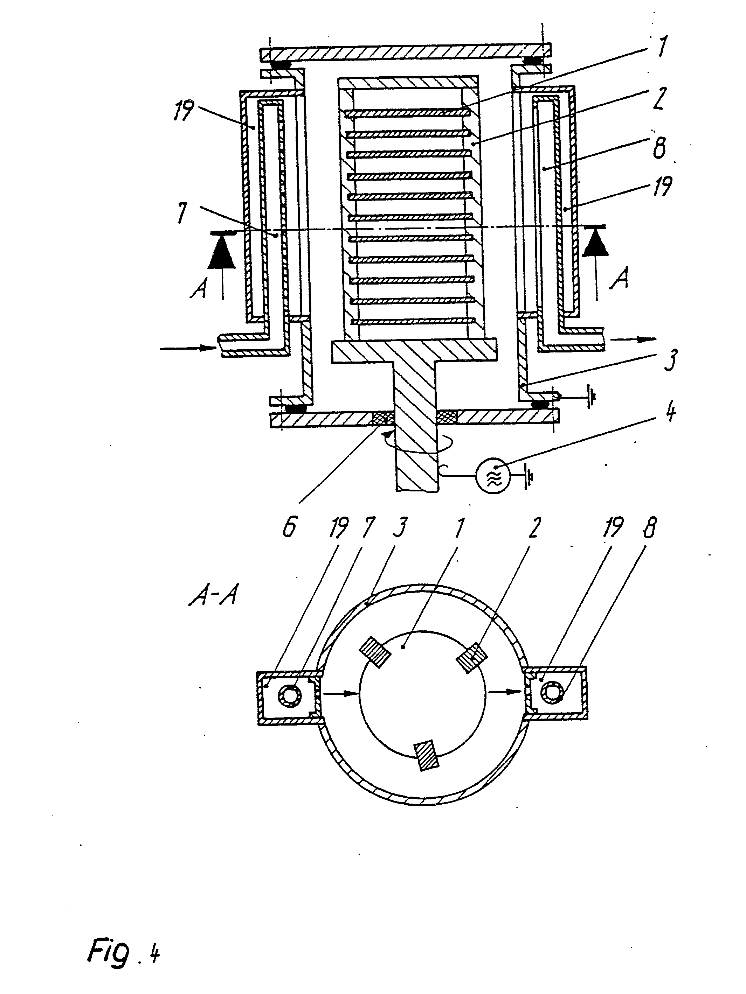

Im Ausführungsbeispiel gemäß Fig. 4 ist eine vertikal aufgebaute Ätzvorrichtung dargestellt. Das Außenrohr 3 des Rohrreaktors besteht aus Metall und ist gleichzeitig als Zylinderelektrode ausgebildet und mit dem Massepotential des HF-Generators 4 verbunden. Die Gaszu- und Gasabführung erfolgt über am Rohrreaktor außen angeordnete Wirbelkammern 19.

Die Substrate 1 sind bei allen Ausführungsbeispielen in der Substrathalterung 2 parallel und im gleichen Abstand zueinander mit der Flächennormalen parallel zur Rohrlängsachse angeordnet. Zur besseren Ausnutzung des Reaktorraumes können die Substrate 1 auch paarweise mit den nicht zu bearbeitenden Flächen direkt aneinander liegend auf gleicher Weise in der Substrathalterung 2 angeordnet werden.

Eine weitere in der Zeichnung nicht dargestellte Möglichkeit der Substratanordnung besteht erfindungsgemäß darin, daß die Substrate mit ihrer Flächennormalen senkrecht zur Rohrlängsachse im Rohrreaktor angeordnet werden. Hierbei ergibt sich ein sehr geringer Aufwand für die Gaszu- und Gasabführung im Rohrreaktor.

Zum Betreiben des Rohrreaktors wird der Gasstrom des jeweiligen Reaktionsgases in die von 4,5—20 mm gewählten Zwischenräume der Substrate so gerichtet, daß er den Substratstapel quer durchströmt und sich dabei im Reaktionsrohr ein Druck im Bereich von 0,01—0,5 kPa aufbaut. Der Abstand der zylinderförmigen Elektrode zur peripheren Begrenzung der Substrate bzw. Substrathalterung wird größer als der Abstand der Substrate zueinander gehalten. Zur Erzeugung eines intensiven und gleichmäßigen Plasmas zwischen den Substraten werden diese mit einer HF-Energiedichte im Bereich von $0,1-0,5$ W/cm$^2$ Scheibenoberfläche beaufschlagt.

Unter diesen Bedingungen bildet sich über die gesamte Scheibenoberfläche — und nur dort — ein gleichmäßiges, intensives Plasma aus, was in Verbindung mit der kurzen Gasführung quer durch den Substratstapel zu einer gleichmäßigen Bearbeitung (Ätzung oder Beschichtung) der gesamten Scheibencharge führt.

Aufstellung der verwendeten Bezugszeichen

1 Substrat
2 Substrathalterung
3 Außenrohr
4 HF-Generator
5 Heizung
6 HF-Drehdurchführung
7 Gaszuführungsrohr
8 Gasabführungsrohr
9 Gegenlager
10 Absaugleitung
11 Gewindeflansch
12 perforierte Elektrode
13 Abstandsring
14 Zylinderelektrode
15 Gasauslaßschlitz
16 doppelwandige Zylinderelektrode
17 isolierender Abstandsring
18 HF-Durchführung
19 Wirbelkammer

**Patentansprüche**

1. Rohrreaktor zur plasmachemischen Dampfphasenabscheidung und zum Plasmaätzen, der im wesentlichen aus einem wahlweise beheizbaren mit einer Gaszu- und Gasableitung sowie mit Anschlüssen für die zur Plasmaerzeugung notwendigen Hochfrequenzenergie versehenen Rohr besteht, in dem eine ein- und ausfahrbare Substrathalterung, auf der die Substrate in stapelförmiger Zuordnung parallel und im gleichen Abstand zueinander vorgesehen sind, angeordnet ist, dadurch gekennzeichnet, daß die Substrathalterung aus einem elektrisch leitenden Material besteht und mit einem Ausgang eines HF-Generators verbunden ist, so daß sich im Betrieb zwischen den einzelnen Substraten des gesamten auf gleichem HF-Potential liegendem Substratstapels ein intensives und gleichmäßiges Plasma bilden kann und daß der Substratstapel in seiner gesamten Länge von einer gegenüber der Substrathalterung isolierten und mit dem anderen Ausgang des HF-Generators verbundenen zylinderförmigen Elektrode umgeben ist.

2. Rohrreaktor nach Anspruch 1, dadurch gekennzeichnet, daß zwischen dem aus einem Isoliermaterial bestehenden Außenrohr des Rohrreaktors und der Substrathalterung ein perforierter Metallzylinder als zylinderförmige Elektrode angeordnet ist, wobei zwischen Außenrohr und zylinderförmiger Elektrode die Gaszu- und Gasabführung angeordnet ist.

3. Rohrreaktor nach Ansprüchen 1 und 2, dadurch gekennzeichnet, daß die zylinderförmige Elektrode aus einem Metallzylinder besteht und die Gaszu- und Gasabführung innerhalb der zylinderförmigen Elektrode angeordnet ist.

4. Rohrreaktor nach Ansprüchen 1 bis 3, dadurch gekennzeichnet, daß die Gaszu- und Gasabführung in der zylinderförmigen Elektrode integriert ist.

5. Rohrreaktor nach Anspruch 4 dadurch gekennzeichnet, daß die z/linderförmige Elektrode aus einer doppelwandigen mit Gasein- und Gasaustrittsöffnungen versehenen topfförmigen Elektrode besteht.

6. Rohrreaktor nach Anspruch 1, dadurch gekennzeichnet, daß das Außenrohr des Rohrreaktors aus Metall oder einem anderen leitfähigen Material besteht und durch Anschluß an einem Ausgang des HF-Generators als zylinderförmige Elektrode ausgebildet ist, in der die mit dem anderen Ausgang des HF-Generators in Wirkungsverbindung stehende Substrathalterung isoliert angeordnet ist.

7. Rohrreaktor nach Ansprüchen 1 bis 6, dadurch gekennzeichnet, daß die Substrathalterung drehbar im Rohrreaktor angeordnet ist.

8. Rohrreaktor nach Ansprüchen 1 bis 7, dadurch gekennzeichnet, daß die zylinderförmige Elektrode mit dem Massepotential des HF-Generators verbunden ist.

9. Rohrreaktor nach Ansprüchen 1 bis 8, dadurch gekennzeichnet, daß die Substrate paarweise mit den nicht zu bearbeitenden Flächen direkt aneinander liegend parallel und im gleichen Abstand zueinander in der Substrathalterung angeordnet sind.

10. Rohrreaktor nach Ansprüchen 1 bis 9, dadurch gekennzeichnet, daß die Substrate mit ihrer Flächennormalen senkrecht zur Rohrlängsachse im Rohrreaktor angeordnet sind.

11. Verfahren zum Betreiben des Rohrreaktors nach Ansprüchen 1 bis 10, dadurch gekennzeichnet, daß ein Gasstrom in die von 4,5—20 mm gewählten Zwischenräume der Substrate so gerichtet wird, daß er den Substratstapel quer durchströmt und sich dabei im Reaktionsrohr ein Druck im Bereich von 0,01—1 kPa aufbaut, wobei der Abstand der zylinderförmigen Elektrode zur peripheren Begrenzung der Substrate bzw. Substrathalterung größer als der Abstand der Substrate zueinander gehalten wird und zur Erzeugung eines intensiven und gleichmäßigen Plasmas zwischen den Substraten werden diese mit einer HF-Energiedichte im Bereich von 0,1—0,5 $W/cm^2$ Scheibenoberfläche beaufschlagt.

## Claims

1. A tubular reactor for plasma chemistry vapour phase separation and plasma etching, essentially comprising a tube which is optionally heated and has a gas supply line and a gas discharge line and connections for the high frequency energy required for plasma generation and in which a removable and insertable substrate retaining means is disposed, on which the substrates are provided in stacked association parallel with and at an equal distance from one another, characterized in that the substrate retaining means comprises an electrically conductive material and is connected to an output of a high frequency generator, so that during operation an intensive and uniform plasma can be formed between the individual substrates of the total substrate stack which is at the same high frequency potential, and in that the substrate stack is enclosed over its whole length by a cylindrical electrode insulated from the substrate retaining means and connected to the other output of the high frequency generator.

2. A tubular reactor according to claim 1, characterized in that the cylindrical electrode takes the form of a perforated metal cylinder disposed between the reactor tube made of an insulating material and the substrate retaining means, the gas supply and gas discharge being disposed between the outer tube and the cylindrical electrode.

3. A tubular reactor according to claims 1 and 2, characterized in that the cylindrical electrode comprises a metal cylinder and the gas supply and gas discharge are disposed inside the cylindrical electrode.

4. A tubular reactor according to claims 1 to 3 characterized in that the gas supply and gas discharge are integrated in the cylindrical electrode.

5. A tubular reactor according to claim 4, characterized in that the cylindrical electrode comprises a double-walled, pot-shaped electrode having gas inlet and gas outlet apertures.

6. A tubular reactor according to claim 1, characterized in that the outer tube of the tubular reactor is made of metal or some other conductive material and by connection to an output of the high frequency generator defines the cylindrical electrode, and in that the substrate retaining means is operatively connected to the other output of the high frequency generator and is insulated therefrom.

7. A tubular reactor according to claims 1 to 6, characterized in that the substrate retaining means is rotatably disposed in the tubular reactor.

8. A tubular reactor according to claims 1 to 7, characterized in that the cylindrical electrode is connected to the ground potential of the high frequency generator.

9. A tubular reactor according to claims 1 to 8, characterized in that the substrates are disposed in the substrate retaining means in pairs, with the surfaces not to be processed bearing directly against one another parallel with and at the same distance from one another.

10. A tubular reactor according to claims 1 to 9, characterized in that the substrates are disposed in the tubular reactor with the plane of their surfaces perpendicular to the longitudinal axis of the tube.

11. A method of operating the tubular reactor according to claims 1 to 10, characterized in that a gas flow is so directed into the gaps, selected from 4.5 to 20 mm, between the substrates that it flows transversely through the substrate stack and a pressure in the range of 0.01 — 1 kPa builds up in the reaction tube, the distance between the cylindrical electrode and the peripheral boundary of the substrates or substrate retaining means being kept larger than the distance of the substrates from one another, and providing a high frequency energy density in the range of 0.1 — 0. 5 W/cm² of disc surface in order to produce an intensive and uniform plasma between the substrates.

## Revendications

1. Réacteur tubulaire pour le dépôt plasmachimique à partir d'une phase gazeuse et pour la gravure au plasma, constitué substantiellement d'un tube pouvant être chauffé, comportant des conduites d'amenée et d'évacuation des gaz ainsi que des connexions pour l'énergie à haute fréquence nécessaire à la production du plasma, ce tube comprenant un support de substrats pouvant être inséré et retiré, sur lequel les substrats sont prévus de former un arrangement en pile de façon parallèle et équidistante, caractérisé en ce que le support de substrats consiste en un matériau électriquement conducteur et est relié à une sortie d'un générateur H.F. de façon qu'un plasma intensif et homogène peut se former, lors de l'opération, entre les substrats individuels de la pile qui est au même potentiel H.F., et que la pile des substrats est entourée, sur toute la longueur, par une électrode cylindrique isolée par rapport au support de substrats et reliée à l'autre sortie du générateur H.F.

2. Réacteur tubulaire selon la revendication 1, caractérisé en ce qu'un cylindre métallique perforé est situé, en tant qu'électrode cylindrique, entre le tube extérieur, consistant d'un matériau isolant, du réacteur et le support de substrats, les conduites d'amenée et d'évacuation des gaz étant arrangées entre le tube extérieur et l'électrode cylindrique.

3. Réacteur tubulaire selon les revendications 1 et 2, caractérisé en ce que l'électrode cylindrique est formée par un cylindre métallique, les conduites d'amenée et d'évacuation des gaz étant placées à l'intérieur de l'électrode cylindrique.

4. Réacteur tubulaire selon les revendications 1 à 3, caractérisé en ce que les conduites d'amenée et d'évacuation des gaz sont intégrées dans l'électrode cyclindrique.

5. Réacteur tubulaire selon la revendication 4, caractérisé en ce que l'électrode cylindrique est une électrode sous forme de pot à paroi double, pourvue d'ouvertures d'entrée et de sortie des gaz.

6. Réacteur tubulaire selon la revendication 1, caractérisé en ce que le tube extérieur du réacteur est en métal ou d'un autre matériau conducteur et agencé comme électrode cylindrique par suite d'une connexion à une sortie de générateur H.F., électrode dans laquelle le support de substrats, étant en connexion fonctionnelle avec l'autre sortie du générateur H.F., est arrangé de façon isolée.

7. Réacteur tubulaire selon les revendications 1 à 6, caractérisé en ce que le support de substrats est monté dans le réacteur de façon pivotable.

8. Réacteur tubulaire selon les revendications 1 à 7, caractérisé en ce que l'électrode cylindrique est reliée au potentiel de masse du générateur H.F.

9. Réacteur tubulaire selon les revendications 1 à 8, caractérisé en ce que les substrats sont arrangés dans le support de substrats par paires parallèles et équidistantes, les surfaces à ne pas être traitées d'une paire se touchant directement.

10. Réacteur tubulaire selon les revendications 1 à 9, caractérisé en ce que les substrats sont arrangés dans le réacteur avec la normale de leurs surfaces perpendiculairement à l'axe longitudinal du réacteur tubulaire.

11. Procédé pour la mise en oeuvre du réacteur tubulaire selon les revendications 1 à 10, caractérisé en ce qu'un jet de gaz est dirigé dans les interstices des substrats choisis entre 4,5 et 20 mm, de telle façon qu'il traverse la pile de substrats transversalement et qu'une pression de 0,01 à 1 kPa se forme dans le tube de réaction, la distance entre l'électrode cylindrique et la limitation périphérique ou, respectivement, le support de substrats étant plus grande que la distance entre les substrats individuels, ces substrats étant chargés d'une densité d'énergie H.F. comprise entre 0,1 et 0,5 W par cm² de surface de substrat afin de créer un plasma intensif et homogène entre les substrats.

A–A

Fig. 1

Fig.2

A-A

Fig. 3

Fig. 4